# EUROPÄISCHE PATENTANMELDUNG

(11) **EP 1 493 836 A1**
(43) Veröffentlichungstag der Anmeldung: **05.01.2005**
(21) Anmeldenummer: 04003349.0
(22) Anmeldetag: 14.02.2004
(51) Int. Cl.: C23C 14/04, C23C 14/56, H01G 13/00

(54) **Verfahren und Vorrichtung zum bereichsweisen Auftragen von Trennmitteln**

(30) Priorität: 04.07.2003 DE 10330401
(71) Anmelder: Applied Films GmbH & Co. KG, 63755 Alzenau (DE)
(72) Erfinder: Hein, Stefan, 63825 Blankenbach (DE)
(74) Vertreter: Zapfe, Hans, Dipl.-Ing.

(57) **Zusammenfassung**

Die Erfindung betrfft ein Verfahren und eine Vorrichtung zum bereichsweisen Auftragen von Trennmitteln mittels eines Verdampfers (1) auf bewegte Substrate (10) in einer Vakuumkammer, die mindestens einen Metallverdampfer (33) aufweist, wobei die Trennmittel in einer ersten Kammer (2) durch Erhitzen verdampft und in Dampfform über mindestens ein Stellventil (12) in eine zweite, mit mindestens einer auf das jeweilige Substrat (10) ausgerichteten Düse (8) versehene Kammer (6) übergeführt werden. Um dabei das aufgedampfte Flächenmuster, die Breite und die Schichtdicke in engen Grenzen konstanthalten und den Dampfaustritt sofort unterbrechen zu können, ist vorgesehen, daß
a) die Verdampfertemperatur so weit wie möglich konstant gehalten wird,
b) der Dampf von der ersten Kammer (2) über das mindestens eine Stellventil (12) gesteuert in die zweite Kammer (6) und in dieser anfänglich parallel zur ersten Kammer (2) der mindestens einen Düse (8) zugeführt wird, und daß
c) das Stellventil (12) bei stillstehendem oder fehlendem Substrat (10) geschlossen und geschlossen gehalten wird.

Vorzugsweise ist das mindestens eine Stellventil (12) ein Proportionalventil, das zwischen der ersten Kammer (2) und der zweiten Kammer (6) angeordnet ist.

## Beschreibung

Die Erfindung betrifft ein Verfahren zum bereichsweisen Auftragen von eine Beschichtung verhindernden Trennmitteln mittels eines Verdampfers auf bewegliche Substrate in einer Vakuumkammer, die mindestens einen Metallverdampfer aufweist, wobei die Trennmittel in einer ersten Kammer durch Erhitzen verdampft und in Dampfform über mindestens ein Stellventil in eine zweite, mit mindestens einer auf das jeweilige Substrat ausgerichteten Düse versehene Kammer übergeführt werden.

Es geht dabei um die Erzeugung von Streifen des Trennmittels, nachfolgend u.a. auch kurz als "ölspuren" bezeichnet, auf den beweglichen bzw. sich bewegenden Substraten. Von solchen "ölspuren" wird erwartet, daß sie ein vorgegebenes konstantes Verteilungsmuster im Hinblick auf die Substratränder, eine konstante Dicke und Breite aufweisen. Auf weitere Forderungen wird weiter unten noch näher eingegangen.

Durch die DE 39 22 187 A1 ist es bekannt, Stoffe, die eine lokale Beschichtung verhindern und auch als Trennmittel bezeichnet werden, in einem beheizten Verdampferrohr zu verdampfen und unmittelbar aus dem Dampfraum über der Flüssigkeit - in aller Regel ein öl - in Düsen zu leiten, die jeweils einen Dampfstrahl auf ein laufendes Band richten, um während des Aufdampfens von Metallen metallfreie Längsstreifen zu erzeugen. Offenbart ist auch eine Fernsehkamera zur Beobachtung des Metallisierungsprozesses, nicht aber des ölauftrags.

Durch die DE 41 00 643 C1 ist es weiterhin bekannt, zusätzliche metallfreie Querstreifen durch eine mit der Bandgeschwindigkeit rotierende Walze zu erzeugen, in die gleichfalls ungehindert Dampf aus dem Dampfraum des Ölverdampfers geleitet wird. Durch einen Temperaturfühler kann die Öltemperatur im Verdampfer überwacht werden.

Durch die DE 42 31 644 A1 ist es bekannt, das Verteilungsmuster der metallfreien Bereiche dadurch zu beeinflussen, das man oberhalb des Dampfraumes und vor den Schlitzdüsen eine bewegliche Blende mit unterschiedlich langen Ausnehmungen und Zungen anbringt. Es wird jedoch ausdrücklich angegeben, daß immer eine Schlitzdüse frei bleiben soll.

Durch die DE 43 09 771 A1 ist es gleichfalls bekannt, Schlitzdüsen unmittelbar über dem Dampfraum des beheizten Verdampfers anzuordnen und die Schichtstärke der Ölschicht durch Steuerung der Heizleistung des Ölverdampfers einzustellen..

Durch die EP 0 966 006 A2 ist es bekannt, Schichtkondensatoren dadurch herzustellen, daß man während einer jeder Umdrehung einer rotierenden, hochglanzpolierten Walze nacheinander eine gehärtete isolierende Harzschicht aus reaktiven monomeren Dämpfen, streifenförmig gemusterte Trennschichten und ebenfalls streifenförmig komplementär dazu gemusterte Metallschichten aus der Gruppe Aluminium, Kupfer, Zink, Nickel, deren Legierungen und Oxiden aufträgt. Eine Hülle von Schichten wird durch eine Vielzahl von bis zu 1800 Umdrehungen in Form von Spiralen erzeugt, bis eine gewünschte elektrostatische Kapazität des Kondensators erreicht ist. Danach wird die vielschichtige Hülle quer zur Drehrichtung aufgeschnitten, von der Walze abgehoben, unter Wärmeeinwirkung flach preßt, weiter zerteilt und mit Elektroden versehen. Messungen der Harzdicke mit Laserlicht sind gleichfalls angegeben. Messungen der Schichtbreiten durch Messung von Reflexionen und Farbkontrasten mittels einer Kamera sind gleichfalls angegeben. Ein mit Düsen versehener Dampfverteiler für das Material der Trennschichten, nämlich Dämpfen aus der Gruppe der öle von Estern, Glykolen, Fluorkohlenstoffen und Kohlenwasserstoffen, ist zwar angegeben, nicht aber Mittel und Maßnahmen für die Steuerung der Dampfmenge und der Schichtdicke und für die Unterbrechung der Dampfströme bei Stillstand der Anlage Es ist sogar ausdrücklich gesagt, daß es nicht nötig ist, die Dicken aller Einzelschichten bei jeder Rotation der Walze zu bestimmen, und daß es ausreichend ist, am Ende eine bestimmte elektrostatische Kapazität zu erreichen. Es genügt z.B. auch eine Schichtdickenbestimmung an einem Meßpunkt ("check-point") nach 15 anfänglichen Umdrehungen der Walze. Für Aluminium ist zwar eine Schichtdicke von 30 nm (300 Å) angegeben, für das Trennmittel ist aber nur gesagt, daß überschüssiges Trennmittel durch eine Plasmaentladung wieder entfernt werden muß. Dadurch entstehen aber - insbesondere bei Halogenverbindungen als Trennmittel - giftige und für das Pumpenöl schädliche Verbindungen. Für die gehärtete Harzschicht ist eine Dicke von nicht mehr als 1 µm angegeben. Im Grunde geht es nur um die Messung und Steuerung oder Regelung der Dicken der Isolierschicht bzw. Harzschicht und der Metallschicht und der Breite der Metall- und der Trennschichten, da diese Größen für die Kapazität des Kondensators maßgebend sind. Ggf. ist eine Wiederholung an bestimmten Meßpunkten ("check-points") nach weiteren Umdrehungen vorgesehen. Mit dem Problem fortgesetzter Austritte von ölen bzw. Trennmitteln in Betriebspausen, sowie mit der Vermeidung von Verlagerungen der ölspuren durch Temperatur- und Längenschwankungen des ölverdampfers setzt sich dieses Dokument überhaupt nicht auseinander.

Die aufgezählten Trennmittel und Metalle und deren Legierungen und Verbindungen sind grundsätzlich auch für den Erfindungsgegenststand verwendbar.

Den vorstehenden Lösungen haften die Nachteile an, daß die Verdampfer wegen ihrer unvermeidbaren Wärmeträgheit auch bei Stillstand der Anlage Öldampf ausstoßen, z.B. beim Bandwechsel oder einer Betriebsstörung, wodurch die Anlage erheblich verunreinigt wird. Verunreinigungen durch Öl sind nur schwer zu beseitigen, zumal sie mit anderen Verunreinigungen eine Schmiere bilden.

Ein weiteres wesentliches Problem ist beim Stande der Technik überhaupt nicht angesprochen: Die thermisch bedingte Längenänderung des Verdampfers beim Aufheizen und Abkühlen. Soll nämlich der Ölausstoß verringert werden, so ist es unerläßlich, die Beheizung des Verdampfers einzustellen und den Verdampfer bei der wieder-in-Betriebnahme aufzuheizen. Dies führt zu Zeitverlusten und allenfalls zu einer Verringerung des ölausstoßes. Eine konstante Verteilung der Düsen und damit der "Ölspuren" längs der Bänder ist aber wesentlich für eine einwandfreie Beschaffenheit der Endprodukte.

Durch die EP 1 035 553 A1 und die EP 0 938 971 A2 sind verschiedene Lösungen zur Unterbrechung des Dampfstromes von einem Verdampfer zu einer Düsenreihe bekannt. Zum Teil befinden sich Absperrventile zwischen Verdampfern, die außerhalb der Vakuumkammer angeordnet sind, und Düsenkörpern im Innern der Vakuumkammer.

Nächstkommender Stand der Technik aus der EP 1 035 553 A1 ist das Beispiel gemäß Figur 7. Der ölverdampfer ist ein beheizbarer Block mit zwei parallelen Kanälen, die durch einen Schlitz für den Dampfdurchtritt miteinander verbunden sind, wobei der Block auf eine Temperatur oberhalb des Siedepunktes des öls aufgeheizt wird. Der untere Kanal ist mit einem Vorrat des Öls gefüllt, und der obere Kanal ist mit einer Düsenreihe für den Dampfaustritt in Richtung auf das Band versehen, um auf diese Weise ölspuren auf dem Band zu erzeugen. Absperr- oder Einstellventile zwischen den beiden Kanälen sind nicht offenbart; ein einziges externes Absperrventil ist nur zwischen einem ebenfalls externen Vorratsbehälter für das kalte Öl und dem unteren internen Vorratskanal für das flüssige Öl vorhanden. Damit läßt sich aber wiederum nicht verhindern, daß öldämpfe auch nach dem Abschalten des Flüssigkeitsventils durch die Düsenreihe in die Vakuumkammer der Anlage austreten und dort kondensieren. Auch ist das Problem der Längenänderung des ölverdampfers bei Temperaturänderungen nicht angesprochen. Wesentlich ist aber die Aussage, daß hierdurch zwar eine sehr einfache Anordnung erzielt werden kann, daß diese aber dem Einfluß einer Druckänderung des Trennmittels (Öls) ausgesetzt ist, so daß die ausgestoßene Ölmenge dazu tendiert, instabil zu werden.

Der Erfindung liegt daher die Aufgabe zugrunde, bei einem Verfahren der eingangs beschriebenen Gattung, d.h. mit einem Vorrat an flüssigem Trennmittel in einem Zwei-Kammer-Verdampfer mit einer Dampf-Verteilerkammer und Düsen innerhalb der Vakuumkammer dahingehend zu verbessern, daß trotz Konstanthaltung der Verdampfertemperatur die aus den Düsen austretenden Dampfmengen gezielt variiert werden können und nicht von Zufälligkeiten abhängig sind, und daß der Dampfaustritt gegebenenfalls auch praktisch sofort unterbrochen werden kann.

Die Lösung der gestellten Aufgabe erfolgt bei dem eingangs angegebenen Verfahren erfindungsgemäß dadurch, daß
a) die Verdampfertemperatur so weit wie möglich konstant gehalten wird,
b) der Dampf von der ersten Kammer über das mindestens eine Stellventil gesteuert in die zweite Kammer und in dieser anfänglich parallel zur ersten Kammer der mindestens einen Düse zugeführt wird, und daß
c) das Stellventil bei stillstehendem oder fehlendem Band geschlossen und geschlossen gehalten wird.

Der Begriff "Steuerung" schließt immer auch eine "Regelung" durch einen oder mehrere geschlossenene Regelkreise ein.

Durch diese Lösung wird die gestellte Aufgabe in vollem Umfange gelöst, d.h. durch die Konstanthaltung der Verdampfertemperatur bleiben die Länge des Verdampfers und damit das Verteilungsmuster der Düsen und der von ihnen erzeugten ölspuren konstant, und die aus den Düsen austretenden Dampfmengen können verfahrensabhängig gesteuert, und der Dampfaustritt kann gegebenenfalls auch praktisch sofort unterbrochen werden, so daß eine Verunreinigung der Vakuumkammer und ihrer komplex verteilten Einbauten durch ölkondensation praktisch vermieden werden können und damit auch ein häufige, schwierige und arbeitsintensive Reinigung der Anlage.

Weitere vorteilhafte Ausgestaltungen des erfindungsgemäßen Verfahrens ergeben sich aus den übrigen Verfahrensansprüchen und aus der Detailbeschreibung, insbesondere auch aus Kombinationen und Unterkombinationen, nämlich dann wenn
* das in der ersten Kammer enthaltene flüssige Trennmittel durch mindestens einen eingetauchten elektrischen Heizkörper auf einer konstanten Temperatur gehalten wird und wenn zumindest die Wandung der zweiten Kammer und damit die mindestens eine Düse durch mindestens einen weiteren elektrischen Heizkörper gleichfalls auf einer konstanten Temperatur gehalten wird, die oberhalb der Siedetemperatur des Trennmittels gewählt wird,
* die erste Kammer unten und die zweite Kammer in einer höheren Lage angeordnet sind, und wenn das dampfförmige Trennmittel mit einer senkrechten Richtungskomponente von unten gegen ein bandförmiges Substrat gerichtet wird,
* die erste Kammer oben und die zweite Kammer in einer tieferen Lage angeordnet sind, und wenn das dampfförmige Trennmittel mit einer senkrechten Richtungskomponente von oben gegen ein plattenförmiges Substrat gerichtet wird,
* die Wandungstemperatur der zweiten Kammer auf einen höheren Wert eingestellt wird als die Trennmitteltemperatur in der ersten Kammer,
* die Heizleistung des eingetauchten Heizkörpers in Abhängigkeit von der Trennmitteltemperatur eingestellt wird,
* die Heizleistung des oberen Heizkörpers für die mindestens eine Düse in Abhängigkeit von der Düsentemperatur eingestellt wird,
* die von der ersten Kammer in die zweite Kammer pro Zeiteinheit überströmende Dampfmenge durch das mindestens eine proportionale Stellventil in Abhängigkeit vom Trennmittelbedarf für die mindenstens eine Düse eingestellt wird,
* die aus der mindestens einen Düse pro Zeiteinheit austretende Dampfmenge des Trennmittels in Abhängigkeit von der Schichtdicke und der Breite der Ölspur(en) sowie der Transportgeschwindigkeit des Bandes eingestellt wird,
* die Schichtdicke der Ölspur(en) proportional zu der pro Zeiteinheit durch den Metallverdampfer verdampften Metallmenge eingestellt wird,
* die mindestens eine ölspur durch ein Beobachtungsfeld hindurchgeführt wird, in dem eine optische Kontrolle der Ölspur(en) durchgeführt wird,
* die für die Ausbildung des Verteilungsmusters und der notwendigen Dicke der Ölspur(en) maßgeblichen Betriebsparameter einem Steuersystem zugeführt werden, in dem sie in Stellgrößen für die Steuerung und/oder Regelung des Verdampfers für das Trennmittel umgesetzt werden, und/oder, wenn
* die für die Ausbildung der Metallbeschichtung maßgeblichen Betriebsparameter gleichfalls dem Steuersystem zugeführt werden, in dem sie in Stellgrößen für die Steuerung und/oder Regelung des Metallverdampfers umgesetzt werden.

Die Erfindung betrifft auch eine Vorrichtung zur Lösung der gleichen Aufgabe. Diese Vorrichtung geht von folgendem Stande der Technik aus, nämlich von einer

Vorrichtung zum bereichsweisen Auftragen von eine Beschichtung verhindernden Trennmitteln mittels eines beheizbaren Verdampfers auf bewegliche Substrate in einer Vakuumkammer, die mindestens einen Metallverdampfer aufweist, wobei der Trennmittel-Verdampfer eine erste Kammer mit mindestens einem Heizkörper für die Verdampfung der Trennmittel aufweist, sowie eine zweite Kammer, die parallel zur ersten Kammer verläuft, mit dieser verbunden ist und mindestens eine auf das jeweilige Band ausgerichtete Düse aufweist, und mit mindestens einem Stellventil für die Absperrung der Trennmittelzufuhr.

Die Lösung der gestellten Aufgabe erfolgt bei einer solchen Vorrichtung erfindungsgemäß dadurch, daß
a) das mindestens eine Stellventil ein Proportionalventil ist, das zwischen der ersten Kammer und der zweiten Kammer angeordnet ist,
b) das Stellventil in jeweils einem Kanal des Trennmittel-Verdampfers angeordnet ist, welcher Kanal die erste Kammer mit der zweiten Kammer verbindet, und daß
c) das Stellventil derart ausgebildet ist, daß der Dampfstrom des Trennmittels sowohl mengenmäßig gezielt einstellbar als auch vollständig unterbrechbar ist.

Weitere vorteilhafte Ausgestaltungen der erfindungsgemäßen Vorrichtung ergeben sich aus den übrigen Vorrichtungsansprüchen und aus der Detailbeschreibung, insbesondere auch aus Kombinationen und Unterkombinationen, nämlich dann wenn
* die erste Kammer unten und die zweite Kammer in einer höheren Lage angeordnet sind, und wenn das dampfförmige Trennmittel mit einer senkrechten Richtungskomponente von unten gegen ein bandförmiges Substrat richtbar ist,
* die erste Kammer oben und die zweite Kammer in einer tieferen Lage angeordnet sind, und wenn das dampfförmige Trennmittel mit einer senkrechten Richtungskomponente von oben gegen ein plattenförmiges Substrat gerichtet wird,
* in der ersten Kammer für das flüssige Trennmittel mindestens ein elektrischer Heizkörper angeordnet ist und wenn zumindest die Wandung der zweiten Kammer und damit die mindestens eine Düse in einem Wärmekontakt mit mindestens einem weiteren elektrischen Heizkörper steht,
* der Trennmittel-Verdampfer eine quaderförmige Kammer mit einem Boden und seitlichen Flanschen aufweist, auf die ein Zwischendeckel aufgespannt ist, der in Richtung seiner längsten Ausdehnung eine nach oben offene mittige Ausnehmung besitzt, zu deren beiden Seiten Nuten angeordnet sind, in die der mindestens eine weitere Heizkörper eingebettet ist, und wenn auf den Zwischendeckel eine Düsenleiste aufgespannt ist, die in Richtung ihrer längsten Ausdehnung eine nach unten offene mittige Ausnehmung besitzt, wobei die Ausnehmungen unter Bildung der zweiten Kammer miteinander kommunizieren, von der die mindestens eine Düse ausgeht,
* der Trennmittel-Verdampfer
   a) eine erste quaderförmige Kammer mit einem Boden und seitlichen Flanschen aufweist, auf die ein erster Verschlußdeckel aufgespannt ist,
   b) die zweite Kammer einen Verschlußdeckel besitzt, der in Richtung seiner längsten Ausdehnung eine nach oben offene mittige Ausnehmung besitzt, zu deren beiden Seiten Nuten angeordnet sind, in die der mindestens eine weitere Heizkörper eingebettet ist, und wenn auf die Unterseite des zweiten Verschlußdeckels eine Düsenleiste aufgespannt ist, die in Richtung ihrer längsten Ausdehnung eine nach oben offene mittige Ausnehmung besitzt, wobei die Ausnehmungen unter Bildung der zweiten Kammer miteinander kommunizieren, von der die mindestens eine Düse ausgeht,
* die Düsenleiste gegen eine solche mit anderen Querschnitten der Düsen und/oder einem anderen Verteilungsmuster der Düsen austauschbar ausgebildet ist,
* in der ersten Kammer des Trennmittel-Verdampfers unterhalb eines konstruktiv vorgesehenen Flüssigkeitspiegels ein Temperaturfühler für die Temperatur des Trennmittels angeordnet ist,
* die Düsenleiste eine Ausnehmung mit einer Stirnfläche besitzt, an der ein Temperaturfühler für die Temperatur der Düsenleiste anliegt,
* über dem Trennmittel-Verdampfer eine Umlenkwalze für die Vorgabe eine Laufweges eines bandförmigen Substrates und des Verlaufs von mindestens einer durch die Düse(n) erzeugten Ölspur auf dem Substrat angeordnet ist, und wenn der Umlenkwalze Signalmittel für die Ermittlung der Substratgeschwindigkeit zugeordnet sind,
* unter dem Trennmittel-Verdampfer ein Transportweg für plattenförmige Substrates und des Verlaufs von mindestens einer durch die Düse(n) erzeugten Ölspur auf dem Substrat angeordnet ist, und wenn dem Transportweg Signalmittel für die Ermittlung der Substratgeschwindigkeit zugeordnet sind,
* dem Laufweg der Substrate mit der mindestens einen Ölspur ein Beobachtungsfeld zugeordnet ist, das durch optische Mittel abtastbar ist,
* die Meßsignale von Sensoren für die Temperaturen, die Dampfmenge pro Zeiteinheit, die Ausbildung des Verteilungsmusters und die Dicke der Ölspur(en) einem Steuersystem aufgeschaltet sind, in dem sie in Stellgrößen für die Steuerung und/oder Regelung des Verdampfers für das Trennmittel (14) umsetzbar sind,
* dem Steuersystem eine Meß- und Regelanordnung für die Steuerung der Metallbeschichtung durch den Metallverdampfer aufgeschaltet ist,
* dem Steuersystem eine Eingabetastatur für Stellbefehle und/oder Sollwerte für die Betriebsparameter zugeordnet ist, und/oder, wenn
* dem Steuersystem ein Bildschirm für Meßwerte, Stellbefehle und/oder Sollwerte für die Betriebsparameter zugeordnet ist.

Zwei Ausführungsbeispiele des Erfindungsgegenstandes und ihre Wirkungsweisen werden nachfolgend anhand der Figuren 1 bis 4 näher erläutert.

Es zeigen:
- Figur 1: einen Axialschnitt durch ein Ende eines Verdampfers für einen Trennmittelaustritt senkrecht nach oben, eine achsparalle Seitenansicht eines Ausschnitts einer zugehörigen Umlenkrolle und eines mit dem Trennmittel streifenförmig beschichteten Bandes in Verbindung mit einem stark vereinfachten Blockschaltbild für die Gewinnung von Meßwerten und die Abgabe von Steuer- und Regelsignalen an die einzelnen durch Messung erfaßten Komponenten,
- Figur 2: einen vertikalen Querschnitt durch den Gegenstand von Figur 1 im Bereich einer der Düsen für den Austritt des Trennmittels,
- Figur 3: einen vertikalen Querschnitt analog Figur 2 im Bereich der Temperaturfühler für die Temperatur des flüssigen Trennmittels und die Düsenleiste und
- Figur 4: einen vertikalen Querschnitt analog Figur 2, jedoch mit umgekehrter Dampf-Austrittsrichtung, nämlich nach unten.

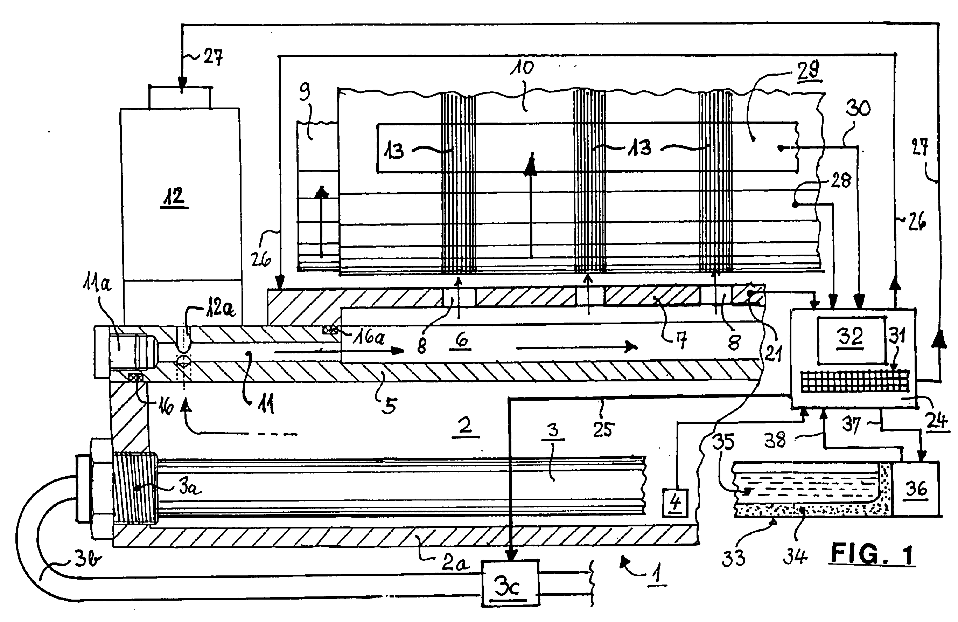

In Figur 1 ist ein Verdampfer 1 für das Trennmittel - nachfolgend kurz als öl bezeichnet - dargestellt. Der Verdampfer 1 ist in einer nicht dargestellten Vakuumkammer angeordnet und besitzt eine untere, etwa quaderförmige Kammer 2 für einen Vorrat des zu verdampfenden öls. In der Nähe des Bodens 2a befindet sich ein in Längsrichtung durchgehender elektrischer Heizkörper 3, der an einem Ende mittels einer Verschraubung 3a mit einem Kabel 3b dicht eingesetzt ist. Im öl selbst befindet sich auch ein Temperaturfühler 4 für die Erfassung der öltemperatur, die beispielsweise auf etwa 110 Grad Celsius eingestellt wird. Das andere Ende des Verdampfers 1 kann, mit Ausnahme der Verschraubung 3a, analog ausgebildet sein.

Der Wert von 110 Grad gilt für die üblichen Trennmittel, beispielsweise solche aus der Gruppe der Polyfluorpolyether, die auch als Vakuumpumpenöle Verwendung finden, beispielsweise unter der Bezeichnung "Fomblin". Solche öle sind hochmolekular und inert, auch gegenüber stark korrosiv wirkenden Medien sowie thermisch stabil und unbrennbar. (RÖMPP Chemie Lexikon, 1995, Georg Thieme Verlag, Stuttgart und New York, Seiten 1421 und 3276, Stichwörter "Fomblin" und "Perfluorpolyether"). Ihre Beimischung zu den Pumpenölen der notwendigerweise vorhandenen Vakuumpumpen ist also unproblematisch.

Die Trennwirkung gegenüber metallischen Beschichtungsstoffen auf Substraten, beispielsweise auf Kunststofffolien und Papierbahnen, z.B. bei der Herstellung von Kondensatoren mit einem Aluminiumbelag, beruht auf einer exakten Schichtdicke des öls: Der ölfilm auf dem Substrat wird durch den kondensierenden Metalldampf erwärmt, wobei das Öl verdampft und durch den Partikelstrom der verdampfenden Moleküle des öls eine Ablagerung des Metalls verhindert. Wird zu wenig Öl aufgetragen, dann ist die Trennwirkung zu gering und auf den metallfrei zu haltenden Streifen des Substrats wird eine dünne Metallschicht aufgetragen, da der ölvorrat auf dem Substrat verbraucht ist, bevor die Metallabscheidung beendet ist. Wird zuviel öl aufgetragen, dann verbleibt eine Ölschicht auf dem Substrat, die beim Aufwickeln von Bändern zwischen zwei Lagen so verteilt wird, daß das Öl über größere Bereiche des teilweise metallisierten Bandes verschmiert wird. Exakte und konstante Dosierung des Trennmittels ist also zwingend vorgeschrieben, aber schwierig zu erreichen.

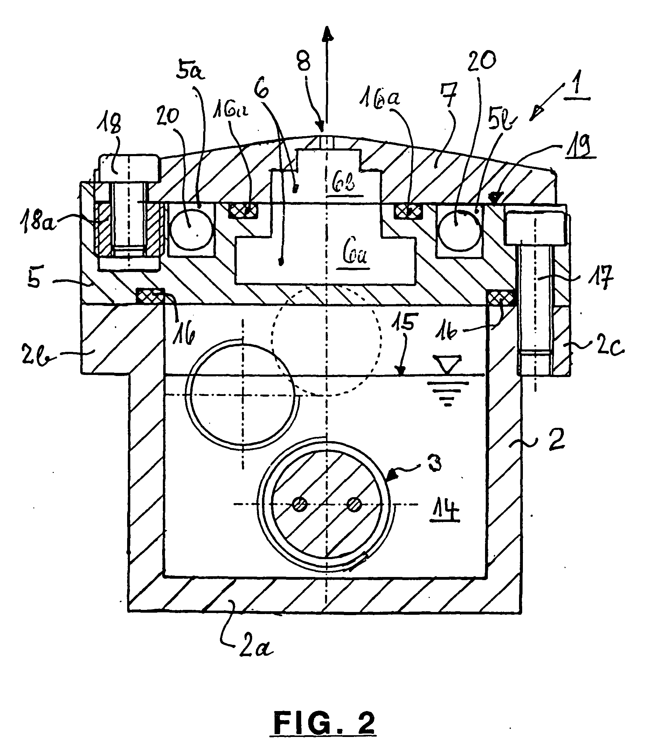

über der Kammer 2 befindet sich abgedichtet ein Zwischendeckel 5 und darin und darüber eine obere, kanalförmige Kammer 6, die parallel zur unteren Kammer 2 verläuft und als Verteilerkanal für dampfförmiges öl dient. über der Kammer 6 ist - wiederum abgedichtet - eine Düsenleiste 7 angeordnet, die in Längsrichtung und nach einem vorgegebenen Verteilungsmuster eine Anzahl von Düsen 8 besitzt. Die Kammer 6 besteht aus zwei linearen Ausnehmungen 6a und 6b, die im Zwischendeckel 5 und in der Düsenleiste 7 ausgebildet sind mit miteinander kommunizieren (siehe Figur 2).

Über der Düsenleiste 7 und parallel zu dieser befindet sich in einem geringen Abstand eine Umlenkwalze 9, über die das zu beschichtende Band 10, eine Kunststofffolie oder ein Papierstreifen von einem Vorratswickel auf einen Fertigwickel umgespult wird, die beide nicht dargestellt sind. Die Laufrichtung ist durch die senkrechten Pfeile angedeutet.

Die untere Kammer 2 ist mit der oberen Kammer 6 über mindestens einen Kanal 11 verbunden, der nach außen hin durch einen Gewindestopfen 11a verschlossen ist, wobei der übergangsquerschnitt und damit die Dampfmenge pro Zeiteinheit durch ein elektrisch gesteuertes Proportionalventil 12 mit einem Ventilkörper 12a beeinflußbar sind, der in den Kanal 11 eingreift. Solche spannungsgesteuerten Proportionalventile 12 sind beispielsweise durch die Firma Bürkert/Deutschland im Handel.

Da der Kanal 6 im Verhältnis zu der Summe der Querschnitte aller Düsen 8 einen verhältnismäßig großen Querschnitt aufweist, ist die aus den einzelnen Düsen 8 austretende Dampfmenge jeweils gleich groß. Die Dampfstrahlen erzeugen auf dem laufenden Band 10 streifenförmige, gleich breite und äquidistante Trennmittel- bzw. ölspuren 13, deren Zweck bereits erläutert wurde. Die Düsenleiste 7 wird auf einer konstanten Temperatur von beispielsweise 120 Grad Celsius gehalten, so daß an ihr, und auch nicht in den Düsen 8 selbst, eine ölkondensation stattfindet, die die Querschnitte verändern könnte.

Die Figur 2 zeigt unter Verwendung gleicher Bezugszeichen wie bisher die quaderförmige Kammer 2 mit seitlichen Flanschen 2b und 2c und einem Vorrat des zu verdampfenden öls 14, der bis zum Flüssigkeitsspiegel 15 reicht. Der Zwischendeckel 5 ist mit den Flanschen 2b und 2c der Kammer 2 unter Zwischenlage von Dichtelementen 16 mittels Schrauben 17 kongruent verschraubt, von denen nur eine sichtbar ist. Auf den Zwischendeckel 5 ist, wiederum unter Zwischenlage von Dichtelementen 16a die Düsenleiste 7 mittels Schrauben 18 und einer thermisch isolierenden Gewindebuchse 18a aufgeschraubt, von denen jeweils nur eine sichtbar ist bzw. sind. Es ist zu erkennen, daß die obere Kammer 6 zumindest im wesentiichen durch Ausfräsungen im Zwischendeckel 5 und in der Düsenleiste 7 gebildet ist.

Unterhalb einer Trennfuge 19 zwischen dem Zwischendeckel 5 und der Düsenleiste 7 befinden sich im Zwischendeckel 5 Nuten 5a und 5b für Heizkörper 20, die im wesentlichen den Zweck haben, die Düsenleiste 7 auf die erforderliche Temperatur zu bringen und dort zu halten.

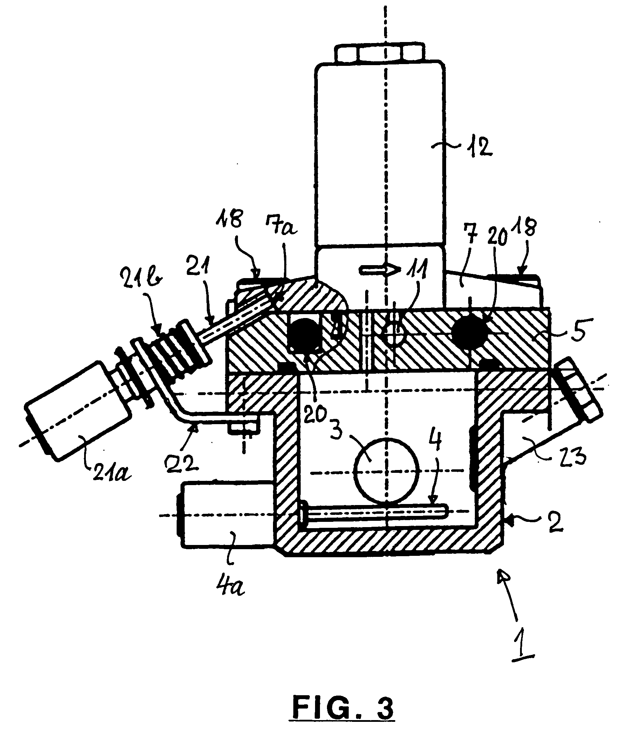

Die Figur 3 zeigt wiederum unter Verwendung gleicher Bezugszeichen wie bisher einen der Praxis entsprechenden Schnitt analog Figur 2 durch den Bereich, in dem ein Temperaturfühler 21 für die Erfassung der Temperatur der Düsenleiste 7 angeordnet ist. Dieser Temperaturfühler 21 ist mit seinem Anschlußgehäuse 21a an einem Winkelstück 22 befestigt und wird mittels einer Druckfeder 21b gegen eine Stirnfläche 7a einer Bohrung in der Düsenleiste 7 gepreßt. Zu sehen ist ferner der Temperaturfühler 4 für das Öl und sein Anschlußgehäuse 4a. Mit 23 ist ein verschließbarer Nachfüllstutzen für das Öl bezeichnet.

Aus der Zusammenschau der Figuren 1, 2 und 3 ergeben sich folgende Möglichkeiten zur Einstellung, Steuerung und/oder Regelung der kritischen Parameter des Verdampfers: Figur 1 zeigt sehr schematisch ein Steuersystem 24. Dieses erhält zunächst über den Temperaturfühler 4 einen Meßwert für die Temperatur des öls, wodurch der Heizkörper 3 mittels eines Leistungsstellers 3c in einem Kabel 3b über die Leitung 25 auf konstante Temperaturwerte eingestellt werden kann. Der Temperaturfühler 21 - hier nur schematisch angedeutet - für die Düsenleiste 7 gibt seinen Meßwert gleichfalls an das Steuersystem 24 weiter, wodurch die Leistung der Heizkörper 20 gemäß Figur 2 über die Leitung 26 eingestellt wird, und zwar gleichfalls auf eine konstante Temperatur.

Ganz besonders wichtig ist die Ansteuerung des Proportionalventils 12 über die Leitung 27. Zu diesem Zweck ist die Umlenkwalze mit einem hier nur sehr schematisch dargestellten Drehzahlgeber 28 versehen, der ein optischer Sensor für die Erfassung von Streifenmustern auf der Umlenkwalze 9 sein kann, oder ein magnetischer Sensor für umlaufende Magnete, oder schlicht ein Drehzahlmesser an der hier nicht gezeigten Welle der Umlenkwalze 9. Da die ölmenge pro Zeiteinheit und Düse im wesentlichen der Bandgeschwindigkeit proportional sein sollte, ist hierdurch eine ideale Möglichkeit zur Optimierung der Dampfströme und der ölschichtdicke gegeben. Beim Stillstand der Umlenkwalze 9 gelangt dadurch das Proportionalventil 12 in seine Schließstellung. Für den gleichen Zweck und bei Betriebsstörungen kann auch ein NOT-AUS-Schalter vorgesehen sein, der in das Steuersystem 24 integriert ist.

Eine zusätzliche optische bzw. visuelle Kontrolle der Öl-Schichtdicke kann in einem Beobachtungsfeld 29 erfolgen, das von den ölspuren 13 durchlaufen wird. Dieses Feld läßt sich beispielsweise durch eine Video-Kamera abrastern, oder es lassen sich die optischen Reflexe zwischen Lichtquellen und Foto-Sensoren über eine Leitung 30 zur manuellen Steuerung oder automatischen Regelung verwenden.

Alle diese Maßnahmen lassen sich entweder einzeln oder in beliebigen Kombinationen anwenden, wobei es jedoch wesentlich ist, daß die Temperaturen des öls und der Düsenleiste 7 während des Betriebes entweder nach Einstellung oder durch Regelung zur Spurhaltung der ölspuren 13 konstant gehalten werden und daß die Dampfströme aus den Düsen 8 bei Stillstand der Anlage in kürzest möglicher Zeit unterbrochen werden.

Zweckmäßig enthält das Steuersystem 24 eine Eingabe-Tastatur 31 für Stellbefehle und/oder Sollwerte und eine LCD-Anzeige und/oder einen Bildschirm 32 für optische Beobachtungen.

Angedeutet ist noch - in stark verkleinertem Maßstab - ein Metallverdampfer 33, bestehend aus einem durch Stromdurchgang beheizten Grafitschiffchen 34, in dem sich eine Schmelze 35, beispielsweise aus Aluminium, befindet. Dieser Metallverdampfer 33 erstreckt sich mindestens über die gesamte Breite des Bandes 10. Zugeordnet ist eine Meß- und Regelanordnung 36, die ihre Steuersignale, z.B. für die Heizleistung, vom Steuersystem 34 über eine Leitung 37 erhält. Bekanntlich ist die pro Zeiteinheit verdampfte Metallmenge der Heizleistung bzw. der Temperatur zumindest im wesentlichen proportional. Eine Rückmeldung der Temperatur und/oder der Heizleistung erfolgt über eine Leitung 38 zum Steuersystem 34. Hierdurch lassen sich die pro Zeiteinheit verdampften öl- und Metallmengen durch das Steuersystem 34 optimiert aufeinander abstimmen, denn die öl- und und Metallmengen entsprechen einander wiederum proportional.

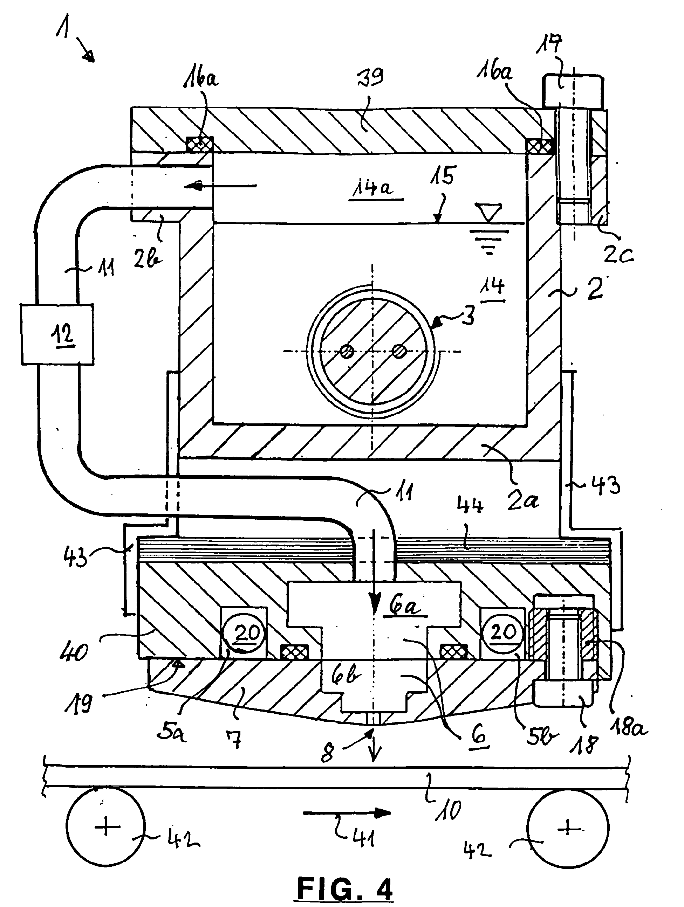

Figur 4 zeigt einen vertikalen Querschnitt analog Figur 2, jedoch mit umgekehrter Dampf-Austrittsrichtung, nämlich nach unten. Es werden weitgehend gleiche Bezugszeichen verwendet, zumal der Gegenstand von Figur 4 weitgehend aus den gleichen Bauteilen besteht wie derjenige nach den Figuren 1 bis 3.

In diesem Falle ist die erste Kammer 2 die obere Kammer und durch einen ersten Verschlußdeckel 39 verschlossen. Der Dampfraum 14a über dem Trennmittel 14 (Öl) ist auch hier mit einem Kanal 11 verbunden, der hier als abgewinkelte Rohrleitung ausgebildet ist und in dem sich das bereits beschriebene Proportionalventil 12 befindet. Die zweite Kammer 6 ist in diesem Fall unterhalb der ersten Kammer 2 angeordnet und gewissermaßen "auf den Kopf gestellt". Der Zwischendeckel 5 nach den Figuren 1 bis 3 ist hier als Verschlußdeckel 40 ausgebildet. Der Kanal 11 mündet durch den zweiten Verschlußdeckel 40 in die zweite Kammer 6, die wiederum aus zwei Ausnehmungen 6a und 6b besteht, die miteinander kommunizieren. Die mindestens eine Düse 8 ist mit ihrer Dampfaustrittsrichtung nach unten auf ein Substrat 10 gerichtet, das biegesteif ist und eine Platte oder Scheibe aus Glas sein kann, z.B. für die spätere Verwendung als LCD-Scheibe. Der Transportweg 41, der sich zwischen Schleusen oder Magazinen befinden kann, ist durch mehrere Transportrollen 42 vorgegeben.

Die zweite Kammer 6 ist über Laschen 43 mit der ersten Kammer 2 verbunden, und die Kammern 2 und 6 bilden eine Baueinheit mit parallelen Kammern 2 und 6. Da die zweite Kammer 6 gegenüber der ersten Kammer 2 üblicherweise eine höhere Betriebstemperatur aufweist, ist eine Wärmedämmschicht 44 zweckmäßig.

Es versteht sich, daß die Raumlage des Trennmittel-Verdampfers 1 je nach den Transportwegen der Substrate unterschiedlich gewählt werden kann, solang die Funktionsfähigkeit der ersten Kammer 2, der Verdampferkammer, erhalten bleibt. Es sind nicht nur Schrägstellungen möglich, sondern die Kammer 6 mit der Düsenleiste 7 kann auch seitlich neben der Kammer 2 angeordnet sein, um z.B. vertikal laufende Bänder zu beschichten. Der Erfindungsgegenstand bildet gewissermaßen ein Baukasten--System, das sich nahezu beliebig umrüsten läßt, wie insbesondere ein Vergleich der Figuren 2 und 4 zeigt.

### Bezugszeichenliste:

- 1: Verdampfer
- 2: erste Kammer
- 2a: Boden
- 2b: Flansch
- 2c: Flansch
- 3: Heizkörper
- 3a: Verschraubung
- 3b: Kabel
- 3c: Leistungssteller
- 4: Temperaturfühler
- 4a: Anschlußgehäuse
- 5: Zwischendeckel
- 5a: Nut
- 5b: Nut
- 6: zweite Kammer
- 6a: Ausnehmung
- 6b: Ausnehmung
- 7: Düsenleiste
- 7a: Stirnfläche
- 8: Düsen
- 9: Umlenkwalze
- 10: Substrat
- 11: Kanal
- 11a: Gewindestopfen
- 12: Proportionalventil
- 12a: Ventilkörper
- 13: Ölspuren
- 14: öl (Trennmittel)
- 14a: Dampfraum
- 15: Flüssigkeitsspiegel
- 16: Dichtelemente
- 16a: Dichtelemente
- 17: Schrauben
- 18: Schrauben
- 18a: Gewindebuchse
- 19: Trennfuge
- 20: Heizkörper
- 21: Temperaturfühler
- 21a: Anschlußgehäuse
- 21b: Druckfeder
- 22: Winkelstück
- 23: Nachfüllstutzen
- 24: Steuersystem
- 25: Leitung
- 26: Leitung
- 27: Leitung
- 28: Drehzahlgeber
- 29: Beobachtungsfeld
- 30: Leitung
- 31: Eingabe-Tastatur
- 32: Bildschirm
- 33: Metallverdampfer
- 34: Grafitschiffchen
- 35: Schmelze
- 36: Meß- und Regelanordnung
- 37: Leitung
- 38: Leitung
- 39: erster Verschlußdeckel
- 40: zweiter Verschlußdeckel
- 41: Transportweg
- 42: Transportrollen
- 43: Laschen
- 44: Wärmedämmschicht

## Patentansprüche

1. Verfahren zum bereichsweisen Auftragen von eine Beschichtung verhindernden Trennmitteln (14) mittels eines Verdampfers (1) auf bewegte Substrate (10) in einer Vakuumkammer, die mindestens einen Metallverdampfer (33) aufweist, wobei die Trennmittel (14) in einer ersten Kammer (2) durch Erhitzen verdampft und in Dampfform über mindestens ein Stellventil (12) in eine zweite, mit mindestens einer auf das jeweilige Substrat (10) ausgerichteten Düse (8) versehene Kammer (6) übergeführt werden, **dadurch gekennzeichnet, daß**
a) die Verdampfertemperatur so weit wie möglich konstant gehalten wird,
b) der Dampf von der ersten Kammer (2) über das mindestens eine Stellventil (12) gesteuert in die zweite Kammer (6) und in dieser anfänglich parallel zur ersten Kammer (2) der mindestens einen Düse (8) zugeführt wird, und daß
c) das Stellventil (12) bei stillstehendem oder fehlendem Substrat (10) geschlossen und geschlossen gehalten wird.

2. Verfahren nach Anspruch 1, **dadurch gekennzeichnet, daß** das in der ersten Kammer (2) enthaltene flüssige Trennmittel (14) durch mindestens einen eingetauchten elektrischen Heizkörper (3) auf einer konstanten Temperatur gehalten wird und daß zumindest die Wandung der zweiten Kammer (6) und damit die mindestens eine Düse (8) durch mindestens einen weiteren elektrischen Heizkörper (20) gleichfalls auf einer konstanten Temperatur gehalten wird, die oberhalb der Siedetemperatur des Trennmittels (14) gewählt wird.

3. Verfahren nach Anspruch 2, **dadurch gekennzeichnet, daß** die erste Kammer (2) unten und die zweite Kammer (6) in einer höheren Lage angeordnet sind, und daß das dampfförmige Trennmittel (14) mit einer senkrechten Richtungskomponente von unten gegen ein bandförmiges Substrat (10) gerichtet wird.

4. Verfahren nach Anspruch 2, **dadurch gekennzeichnet, daß** die erste Kammer (2) oben und die zweite Kammer (6) in einer tieferen Lage angeordnet sind, und daß das dampfförmige Trennmittel (14) mit einer senkrechten Richtungskomponente von oben gegen ein plattenförmiges Substrat (10) gerichtet wird.

5. Verfahren nach mindestens einem der Ansprüche 1 bis 4, **dadurch gekennzeichnet, daß** die Wandungstemperatur der zweiten Kammer (6) auf einen höheren Wert eingestellt wird als die Trennmitteltemperatur in der ersten Kammer (2).

6. Verfahren nach mindesten einem der Ansprüche 1 bis 5, **dadurch gekennzeichnet, daß** die Heizleistung des eingetauchten Heizkörpers (3) in Abhängigkeit von der Trennmitteltemperatur eingestellt wird.

7. Verfahren nach mindestens einem der Ansprüche 1 bis 6, **dadurch gekennzeichnet, daß** die Heizleistung des Heizkörpers (20) für die mindestens eine Düse (8) in Abhängigkeit von der Düsentemperatur eingestellt wird.

8. Verfahren nach mindestens einem der Ansprüche 1 bis 7, **dadurch gekennzeichnet, daß** die von der ersten Kammer (2) in die zweite Kammer (6) pro Zeiteinheit überströmende Dampfmenge durch das mindestens eine proportionale Stellventil (12) in Abhängigkeit vom Trennmittelbedarf für die mindenstens eine Düse (8) eingestellt wird.

9. Verfahren nach mindestens einem der Ansprüche 1 bis 8, **dadurch gekennzeichnet, daß** die aus der mindestens einen Düse (8) pro Zeiteinheit austretende Dampfmenge des Trennmittels (14) in Abhängigkeit von der Schichtdicke und der Breite der Ölspur(en) (13) sowie der Transportgeschwindigkeit des Substrats (10) eingestellt wird.

10. Verfahren nach mindestens einem der Ansprüch 1 bis 9, **dadurch gekennzeichnet, daß** die Schichtdicke der Ölspur(en) (13) proportional zu der pro Zeiteinheit durch den Metallverdampfer (22) verdampften Metallmenge eingestellt wird.

11. Verfahren nach mindestens einem der Ansprüche 1 bis 10, **dadurch gekennzeichnet, daß** die mindestens eine ölspur (13) durch ein Beobachtungsfeld (29) hindurchgeführt wird, in dem eine optische Kontrolle der Ölspur(en) (13) durchgeführt wird.

12. Verfahren nach mindestens einem der Ansprüche 1 bis 11, **dadurch gekennzeichnet, daß** die für die Ausbildung des Verteilungsmusters und der notwendigen Dicke der ölspur(en) (13) maßgeblichen Betriebsparameter einem Steuersystem (24) zugeführt werden, in dem sie in Stellgrößen für die Steuerung und/oder Regelung des Verdampfers (1) für das Trennmittel (14) umgesetzt werden.

13. Verfahren nach mindestens einem der Ansprüche 1 bis 12, **dadurch gekennzeichnet, daß** die für die Ausbildung der Metallbeschichtung maßgeblichen Betriebsparameter gleichfalls dem Steuersystem (24) zugeführt werden, in dem sie in Stellgrößen für die Steuerung und/oder Regelung des Metallverdampfers (33) umgesetzt werden.

14. Vorrichtung zum bereichsweisen Auftragen von eine Beschichtung verhindernden Trennmitteln (14) mittels eines beheizbaren Verdampfers (1) auf bewegte Substrate (10) in einer Vakuumkammer, die mindestens einen Metallverdampfer (33) aufweist, wobei der Trennmittel-Verdampfer (1) eine erste Kammer (2) mit mindestens einem Heizkörper (3) für die Verdampfung der Trennmittel (14) aufweist, sowie eine zweite Kammer (6), die parallel zur ersten Kammer (2) verläuft, mit dieser verbunden ist und mindestens eine auf das jeweilige Substrat (10) ausgerichtete Düse (8) aufweist, und mit mindestens einem Stellventil (12) für die Absperrung der Trennmittelzufuhr,
**dadurch gekennzeichnet, daß**
a) das mindestens eine Stellventil (12) ein Proportionalventil ist, das zwischen der ersten Kammer (2) und der zweiten Kammer (6) angeordnet ist,
b) das Stellventil (12) in jeweils einem Kanal (11) des Trennmittel-Verdampfers (1) angeordnet ist, welcher Kanal (11) die erste Kammer (2) mit der zweiten Kammer (6) verbindet, und daß
c) das Stellventil (12) derart ausgebildet ist, daß der Dampfstrom des Trennmittels (14) sowohl mengenmäßig gezielt einstellbar als auch vollständig unterbrechbar ist.

15. Vorrichtung nach Anspruch 14, **dadurch gekennzeichnet, daß** die erste Kammer (2) unten und die zweite Kammer (6) in einer höheren Lage angeordnet ist, und daß das dampfförmige Trennmittel (14) mit einer senkrechten Richtungskomponente von unten gegen ein bandförmiges Substrat (10) richtbar ist.

16. Vorrichtung nach Anspruch 14, **dadurch gekennzeichnet, daß** die erste Kammer (2) oben und die zweite Kammer (6) in einer tieferen Lage angeordnet ist, und daß das dampfförmige Trennmittel (14) mit einer senkrechten Richtungskomponente von oben gegen ein plattenförmiges Substrat (10) richtbar ist.

17. Vorrichtung nach mindestens einem der Ansprüche 14 bis 16, **dadurch gekennzeichnet, daß** in der ersten Kammer (2) für das flüssige Trennmittel (14) mindestens ein elektrischer Heizkörper (3) angeordnet ist und daß zumindest die Wandung der zweiten Kammer (6) und damit die mindestens eine Düse (8) in einem Wärmekontakt mit mindestens einem weiteren elektrischen Heizkörper (20) steht.

18. Vorrichtung nach mindestens einem der Ansprüche 14, 15 und 17, **dadurch gekennzeichnet, daß** der Trennmittel-Verdampfer (1) eine quaderförmige Kammer (2) mit einem Boden (2a) und seitlichen Flanschen (2b, 2c) aufweist, auf die ein Zwischendeckel (5) aufgespannt ist, der in Richtung seiner längsten Ausdehnung eine nach oben offene mittige Ausnehmung (6a) besitzt, zu deren beiden Seiten Nuten (5a, 5b) angeordnet sind, in die der mindestens eine weitere Heizkörper (20) eingebettet ist, und daß auf den Zwischendeckel (5) eine Düsenleiste (7) aufgespannt ist, die in Richtung ihrer längsten Ausdehnung eine nach unten offene mittige Ausnehmung (6b) besitzt, wobei die Ausnehmungen (6a, 6b) unter Bildung der zweiten Kammer (6) miteinander kommunizieren, von der die mindestens eine Düse (8) ausgeht.

19. Vorrichtung nach mindestens einem der Ansprüche 14, 16 und 17, **dadurch gekennzeichnet, daß** der Trennmittel-Verdampfer (1)
a) eine erste quaderförmige Kammer (2) mit einem Boden (2a) und seitlichen Flanschen (2b, 2c) aufweist, auf die ein erster Verschlußdeckel (39) aufgespannt ist,
b) die zweite Kammer (6) einen zweiten Verschlußdeckel (40) besitzt, der in Richtung seiner längsten Ausdehnung eine nach unten offene mittige Ausnehmung (6a) besitzt, zu deren beiden Seiten Nuten (5a, 5b) angeordnet sind, in die der mindestens eine weitere Heizkörper (20) eingebettet ist, und daß auf die Unterseite des zweiten Verschlußdeckels (40) eine Düsenleiste (7) aufgespannt ist, die in Richtung ihrer längsten Ausdehnung eine nach oben offene mittige Ausnehmung (6b) besitzt, wobei die Ausnehmungen (6a, 6b) unter Bildung der zweiten Kammer (6) miteinander kommunizieren, von der die mindestens eine Düse (8) ausgeht.

20. Vorrichtung nach einem der Ansprüche 19 oder 20, **dadurch gekennzeichnet, daß** die Düsenleiste (7) gegen eine solche mit anderen Querschnitten der Düsen (8) und/oder einem anderen Verteilungsmuster der Düsen (8) austauschbar ausgebildet ist.

21. Vorrichtung nach Anspruch 14, **dadurch gekennzeichnet, daß** in der ersten Kammer (2) des Verdampfers (1) unterhalb eines konstruktiv vorgesehenen Flüssigkeitspiegels (15) ein Temperaturfühler (4) für die Temperatur des Trennmittels (14) angeordnet ist.

22. Vorrichtung nach einem der Ansprüche 18 oder 19, **dadurch gekennzeichnet, daß** die Düsenleiste (7) eine Ausnehmung mit einer Stirnfläche (7a) besitzt, an der ein Temperaturfühler (21) für die Temperatur der Düsenleiste anliegt.

23. Vorrichtung nach Anspruch 14, **dadurch gekennzeichnet, daß** über dem Trennmittel-Verdampfer (1) eine Umlenkwalze (9) für die Vorgabe eine Laufweges eines bandförmigen Substrates (10) und des Verlaufs von mindestens einer durch die Düse(n) (8) erzeugten ölspur (13) auf dem Substrat (10) angeordnet ist, und daß der Umlenkwalze (9) Signalmittel für die Ermittlung der Substratgeschwindigkeit zugeordnet sind.

24. Vorrichtung nach Anspruch 14, **dadurch gekennzeichnet, daß** unter dem Trennmittel-Verdampfer (1) ein Transportweg (41) für plattenförmige Substrate (10) und des Verlaufs von mindestens einer durch die Düse(n) (8) erzeugten ölspur (13) auf dem Substrat (10) angeordnet ist, und daß dem Transportweg (41) Signalmittel für die Ermittlung der Substratgeschwindigkeit zugeordnet sind.

25. Vorrichtung nach mindestens einem der Ansprüche 15 und 16, **dadurch gekennzeichnet, daß** dem Laufweg der Substrate (10) mit der mindestens einen Ölspur (13) ein Beobachtungsfeld (29) zugeordnet ist, das durch optische Mittel abtastbar ist.

26. Vorrichtung nach mindestens einem der Ansprüche 14 bis 25, **dadurch gekennzeichnet, daß** die Meßsignale von Sensoren für die Temperaturen, die Dampfmenge pro Zeiteinheit, die Ausbildung des Verteilungsmusters und die Dicke der ölspur(en) (13) einem Steuersystem (24) aufgeschaltet sind, in dem sie in Stellgrößen für die Steuerung und/oder Regelung des Verdampfers (1) für das Trennmittel (14) umsetzbar sind.

27. Vorrichtung nach Anspruch 26, **dadurch gekennzeichnet, daß** dem Steuersystem (24) eine Meß- und Regelanordnung (36) für die Steuerung der Metallbeschichtung durch den Metallverdampfer (33) aufgeschaltet ist.

28. Vorrichtung nach Anspruch 26, **dadurch gekennzeichnet, daß** dem Steuersystem (24) eine Eingabetastatur (31) für Stellbefehle und/oder Sollwerte für die Betriebsparameter zugeordnet ist.

29. Vorrichtung nach Anspruch 26, **dadurch gekennzeichnet, daß** dem Steuersystem (24) ein Bildschirm (32) für Meßwerte, Stellbefehle und/oder Sollwerte für die Betriebsparameter zugeordnet ist.
